Europäisches Patentamt

European Patent Office

Office européen des brevets

(11) Veröffentlichungsnummer: **0 008 630**
**A1**

## (12) EUROPÄISCHE PATENTANMELDUNG

(21) Anmeldenummer: **79102295.7**

(22) Anmeldetag: **05.07.79**

(51) Int. Cl.$^3$: **G 01 R 21/00**
**G 01 R 11/00, G 01 R 15/08**
**H 03 K 13/02**

(30) Priorität: **17.07.78 DE 2831407**

(43) Veröffentlichungstag der Anmeldung:
**19.03.80 Patentblatt 80/6**

(84) Benannte Vertragsstaaten:
**AT CH DE FR GB**

(71) Anmelder: **SIEMENS AKTIENGESELLSCHAFT Berlin**
**und München**
**Postfach 261**
**D-8000 München 22(DE)**

(72) Erfinder: **Steinmüller, Günter**
**Laufamholzstrasse 65**
**D-8500 Nürnberg(DE)**

(54) **Leistungsfrequenzwandler mit einem Mikrocomputer.**

(57) Bei einem Leistungsfrequenzwandler mit Mikrocomputer (1) werden dem letzteren die zu multiplizierenden analogen Größen über Analog-Digital-Wandler (2) zugeführt. Will man die analogen Größen mit einer Genauigkeit von 1% über einen größeren Meßbereich erfassen, so ist ein A/D-Wandler (2) und ein Mikrocomputer (1) mit einer entsprechenden Auflösung notwendig. Um mit nicht so aufwendigen Mikrocomputern (1) und besonders A/D-Wandlern (2) bei entsprechendem Meßbereich auskommen zu können, wird gemäß der Erfindung dem A/D-Wandler (2) ein Verstärker (3) vorgeschaltet, dem die analogen Größen über Widerstände (6-11) eines Widerstandsnetzwerkes (4) zugeführt sind, wobei die entsprechenden Widerstandswerte von dem Mikrocomputer (1) vorwählbar sind.

EP 0 008 630 A1

./....

SIEMENS AKTIENGESELLSCHAFT          Unser Zeichen
Berlin und München                  VPA 78 P 3 1 2 1 EUR

Leistungsfrequenzwandler mit einem Mikrocomputer

Die Erfindung bezieht sich auf einen Leistungsfrequenzwandler mit einem Mikrocomputer, dem die zu multiplizierenden analogen Größen über Analog-Digital-Wandler zugeführt sind.

Leistungsfrequenzwandler geben eine einer anliegenden
elektrischen Leistung proportionale Impulsfrequenz ab.
Wird die abgegebene Impulsfrequenz über die Zeit integriert, spricht man von einem Elektrizitätszähler. Bei
bekannten elektronischen Elektrizitätszählern besteht der
Leistungsfrequenzwandler meist aus einem Multiplikator
zur Leistungsbildung und einem diesem nachgeschalteten
Strom-Frequenz-Wandler. Es wurde aber auch schon ein
Elektrizitätszähler mit Mikrocomputer vorgeschlagen, wobei dem Mikrocomputer die analogen Größen von Strom und
Spannung über Analog-Digital-Wandler zugeführt werden.
Hierbei wird im Mikrocomputer sowohl das Produkt aus
Strom x Spannung gebildet als auch eine Quantisierung

0008630

vorgenommen, um den Verbrauch digital anzeigen zu können. Will man beispielsweise die dem Laststrom proportionale Größe mit einer Genauigkeit von 1 % über den gesamten Lastbereich erfassen, so ist ein Analog-Digital-Wandler mit einer entsprechenden Auflösung notwendig. Will man beispielsweise einen Lastbereich von 5 % $I_n$ bis 600 % $I_n$ bei einer Genauigkeit von 1 % erfassen, so benötigt man einen Analog-Digital-Wandler mit einer Auflösung von 14 bit. Dieser Lastbereich entspricht einem Bereich von 1 bis 120. Bei einer Auflösung der kleinsten Spannung auf 1 % entspricht dies 0,01 bis 120 oder 1 bis 12 000. Beispielsweise ist mit einem 13bit-Wandler eine Auflösung von 8 192 bit und mit einem 14bit-Wandler eine entsprechende Auflösung von 1 bis 16 384 möglich.

Mikrocomputer und besonders Analog-Digital-Wandler mit mehr als 8 bit sind sehr teuer, so daß bei einem solchen geforderten Meßbereich ein Elektrizitätszähler mit Mikrocomputer aus wirtschaftlichen Gründen meist ausscheidet. Der Erfindung liegt die Aufgabe zugrunde, einen Leistungsfrequenzwandler der eingangs genannten Art derart weiterzubilden, daß ohne wesentlichen Mehraufwand der Meßbereich erheblich erweitert werden kann. Diese Aufgabe wird gemäß der Erfindung dadurch erreicht, daß dem Analog-Digital-Wandler ein Verstärker vorgeschaltet ist, dem die analoge Größe über vorschaltbare Widerstände eines Widerstandsnetzwerkes zugeführt sind, die von dem Mikrocomputer vorwählbar sind.

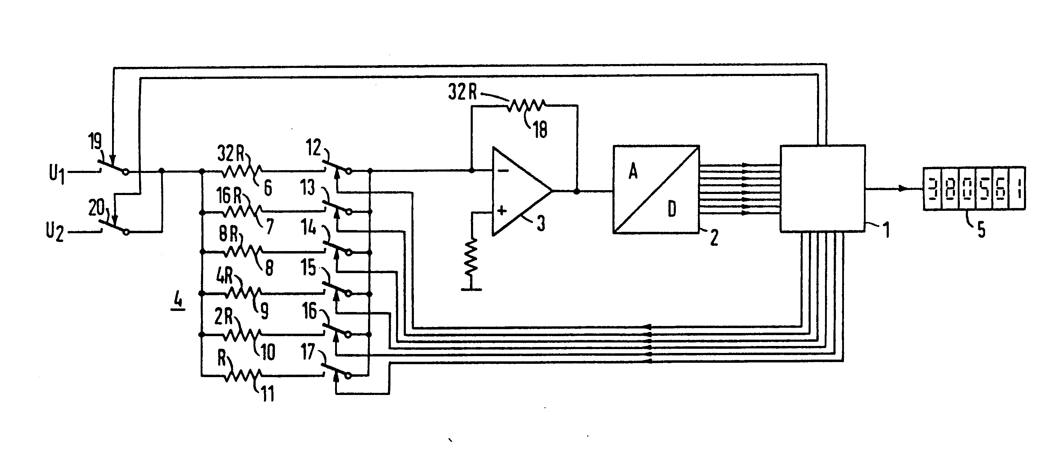

Anhand der Zeichnung, in der ein Ausführungsbeispiel im Prinzip dargestellt ist, wird die Erfindung näher erläutert.

Als Ausführungsbeispiel wurde ein Leistungsfrequenzwandler mit Mikrocomputer gewählt, dem die zu multiplizierenden Größen $U_1$ und $U_2$ zugeführt werden. Hierbei kann die

Spannung $U_1$ proportional dem Strom und die Spannung $U_2$ proportional der Netzspannung sein. Mit 1 ist ein Mikrocomputer bezeichnet, dem ein Analog-Digital-Wandler 2 zugeordnet ist. Dem Analog-Digital-Wandler 2 werden die analogen Größen $U_1$ und $U_2$ über einen Verstärker 3 zugeführt, dem ein Widerstandsnetzwerk 4 vorgeschaltet ist. Am Ausgang des Mikrocomputers 1 ist ein Zählwerk 5 angeschlossen, das je nach der Arbeitsweise einen Leistungswert oder einen Verbrauchswert angeben kann.

Das Widerstandsnetzwerk 4 besteht aus sechs parallelgeschalteten Widerständen 6 bis 11, die mit Hilfe von Schaltern 12 bis 17 zur Wirkung gebracht werden können. Wie aus der Zeichnung ersichtlich, sind die Widerstandswerte dual abgestimmt und zwar von R bis 32R. Bei dem gewählten Ausführungsbeispiel entspricht der Widerstandswert des dem Verstärker 3 zugeordneten Widerstandes 18 dem Widerstandswert des Widerstandes 6 des Widerstandsnetzwerkes 4 und zwar ebenfalls 32R. Das bedeutet, wird der Schalter 12 geschlossen, so ist die Verstärkung des Verstärkers 3 gleich 1, da die Werte der Widerstände 6 und 18 gleich sind. Über Schalter 19 und 20 können die analogen Größen $U_1$ und $U_2$ wechselweise zur Wirkung gebracht werden. Die Schalter 19 und 20 werden ebenfalls wie die Schalter 12 bis 17 vom Mikrocomputer 1 angesteurt, wie zu ersehen ist. Bei dem in der Zeichnung dargestellten Widerstandsnetzwerk 4 sind nur sechs Widerstände gezeichnet. Es ist selbstverständlich, daß die Zahl der Widerstände und die Abstufung der Widerstandswerte der einzelnen Widerstände beliebig gewählt werden kann. Wie aus der Zeichnung zu ersehen ist, sind der Mikrocomputer 1 und der Analog-Digital-Wandler 2 für 8 bit ausgelegt, da Mikrocomputer und besonders Analog-Digital-Wandler mit mehr als 8 bit sehr teuer sind. Dadurch, daß dem Analog-Digital-Wandler 2 der Verstärker 3 mit dem Widerstandsnetzwerk 4 vorgeschaltet ist, kann mit dem dargestellten 8bit-Analog-Digital-Wandler und dem 8bit-Mikrocomputer 1 die gleiche Genauigkeit erreicht werden, wie mit einem 14bit-Analog-Digital-Wandler und einem 14bit-Mikrocomputer, d.h., es kann damit ein Lastbereich von 5 bis 600 % $I_n$ mit einem Fehler $< 1$ % beherrscht werden.

Zu Beginn sei angenommen, daß dem Mikrocomputer 1 die analoge Größe $U_1$ zugeführt werden soll, die beispielsweise proportional dem Laststrom sein soll. Zu einem vom Mikrocomputer 1 gegebenen Zeitpunkt werden die beiden Schalter 12 und 19 geschlossen. Die Spannung $U_1$ wird nun ohne Verstärkung auf den Eingang des Analog-Digital-Wandlers 2 geschaltet, da - wie zuvor ausgeführt - die beiden Widerstände 6 und 18 gleich sind, so daß $V = 1$ ist. Der Analog-Digital-Wandler 2 wandelt in an sich bekannter Weise den analogen Wert in einen 8bit-codierten Wert um wie durch die acht Linien zwischen Analog-Digital-Wandler 2 und Mikrocomputer 1 angedeutet ist. Dieser 8bit-Wert wird vom Mikrocomputer 1 übernommen. Dieser vergleicht die gewandelte Spannung mit der maximalen zulässigen Eingangsspannung des AID-Wandlers und errechnet die noch zulässige Verstärkung. Diese wird nun mit einem der Schalter 12 bis 17 eingestellt. Wird beispielsweise der Schalter 17 geschlossen, so ist die Verstärkung $V = 32R/1R = 32$, so daß nun eine um den Faktor 32 höhere Eingangsspannung an den Eingang des Analog-Digital-Wandlers 2 gelangt. Dieser analoge Wert wird nun wieder in einen digitalen Wert umgewandelt und durch die im Mikrocomputer 1 gespeicherte Verstärkung dividiert. Der somit erhaltene Wert ist ein Maß für den Laststrom mit einer Genauigkeit über den gesamten Lastbereich von $< 1$ %. Das gleiche geschieht nun mit der Spannung $U_2$, die proportional der Netzspannung ist. Zu diesem Zweck wird vom Mikrocomputer 1 der Schalter 20 geschlossen, so daß die der Netzspannung proportionale Spannung $U_2$ über den Widerstand 6 und geschlossenen Schalter 12 dem invertierenden Eingang des Verstärkers 3 zugeführt wird. Die Spannung $U_2$ wird nun wiederum ohne Verstärkung, da $V = 32R$ $32R = 1$, auf den Eingang des Analog-Digital-Wandlers 2 geschaltet, umgewandelt und von dem Mikrocomputer 1 übernommen. Dieser vergleicht die gewandelte Spannung mit der maximal zulässigen Eingangsspannung des Verstärkers und errechnet die noch zulässige Verstärkung. Dieser analoge Wert wird nun wieder in einen Digitalwert umgewandelt und durch die im Mikrocomputer gespeicherte Verstärkung dividiert. Der somit erhaltene Wert ist ein Maß für die Netzspannung. Dieser Wert wird anschließend im Mikrocomputer in an sich bekannter Weise mit dem Digitalwert des Stromes multipliziert, summiert und quantisiert und mit Hilfe des Zählwerkes 5 angezeigt.

Anstelle der in der Zeichnung dargestellten elektromechanischen Schalter können zweckmäßigerweise elektronische Schalter, wie bipolare Transistoren oder Feldeffekttransistoren, verwendet werden.

Neue Patentansprüche 1 bis 3

(ersetzen die bisherigen
Ansprüche 1 bis 4)

Unser Zeichen
VPA 78 P 3121 EUR

Aktenzeichen
79102295.7

1. Elektronische Meßeinrichtung für analoge elektrische Signale, bei der die Signale über einen Verstärker einem Analog-Digital-Wandler zugeführt sind, der ausgangsseitig mit einer Auswerteeinheit verbunden ist, wobei die analogen elektrischen Signale über durch eine Auswahlschaltung vorwählbare einschaltbare Widerstände eines Widerstandsnetzwerkes am Eingang des Verstärkers anstehen, d a d u r c h   g e k e n n z e i c h n e t , daß zur Leistungs-Frequenz-Wandlung wechselweise über Schalter (19, 20) dem Laststom und der Neztspannung proportionale Signale (U1, U2) über das gleiche Widerstandsnetzwerk (4) und den Verstärker (3) zur Wirkung gebracht werden, daß als Auswerteeinheit ein Mikrocomputer (1) vorgesehen ist, der die Schalter (19, 20) steuert und durch Einschalten (12 bis 17) der vorwählbaren Widerstände (6 bis 11) im Rahmen eines Konversionszyklus des Analog-Digital-Wandlers (2) einen solchen Verstärkungsfaktor des Verstärkers (3) einstellt, daß das Ausgangssignal des Verstärkers die maximal zulässige Eingangsspannung des Analog-Digital-Wandlers (2) nicht übersteigt, daß der eingestellte Verstärkungsfaktor in einen Speicher des Mikrocomputers (1) übernommen wird, daß das Ausgangssignal des Analog-Digital-Wandlers (2) mit dem gespeicherten Wert dividiert wird und daß durch den Mikrocomputer (1) die Multiplikation zusammengehöriger Paare (U1, U2) der dividierten digitalisierten Eingangswerte durchgeführt, die erhaltenen Werte summiert und quantisiert werden.

Spl 2 N.N. / 20.12.1979

2. Elektronische Meßeinrichtung nach Anspruch 1 , d a - d u r c h   g e k e n n z e i c h n e t , daß die Widerstandswerte der vorwählbaren Widerstände (6 bis 11) dual abgestuft sind.

3. Elektronische Meßeinrichtung nach Anspruch 1 oder 2, d a d u r c h   g e k e n n z e i c h n e t, daß der zuerst angewählte Widerstand (6) den gleichen Wert hat wie ein zwischen Ausgang und invertierendem Eingang des Verstärkers (3) geschalteter Widerstand (18).

0008630

Patentansprüche

1. Leistungsfrequenzwandler mit einem Mikrocomputer, dem die zu multiplizierenden analogen Größen über Analog-Digital-Wandler zugeführt sind, d a d u r c h  g e - k e n n z e i c h n e t , daß dem Analog-Digital-Wandler (2) ein Verstärker (3) vorgeschaltet ist, dem die analogen Größen über vorwählbare Widerstände ( 6 bis 11) eines Widerstandsnetzwerkes (4) zugeführt sind, die von dem Mikrocomputer (1) vorwählbar sind.

2. Leistungsfrequenzwandler nach Anspruch 1, d a d u r c h g e k e n n z e i c h n e t, daß die Widerstandswerte der vorwählbaren Widerstände (6 bis 11) dual abgestuft sind.

3. Leistungsfrequenzwandler nach Anspruch 1 oder 2, d a d u r c h  g e k e n n z e i c h n e t, daß der zuerst angewählte Widerstand (6) den gleichen Wert hat wie der zwischen Ausgang und invertierendem Eingang des Verstärkers (3) geschaltete Widerstand (18).

4. Leistungsfrequenzwandler nach einem der Ansprüche 1 bis 3, d a d u r c h  g e k e n n z e i c h n e t, daß die zu multiplizierenden analogen Größen wechselweise über das gleiche Widerstandsnetzwerk (4) und Verstärker (3) zur Wirkung gebracht sind.

000863

Europäisches
Patentamt

**EUROPÄISCHER RECHERCHENBERICHT**

Nummer der Anmeldung

EP 79 102 295.7

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | DE - A - 2 116 161 (BECKER)<br>* Seite 1 bis Seite 2, Absatz 3 *<br>--- | 1 |
| | DE - A1 - 2·539 344 (GENERAL ELECTRIC)<br>* Anspruch 3, 4; Seite 2, Absatz 2<br>bis Seite 3, Absatz 2; Seite 6;<br>Fig. 2 *<br>— | 1 |
| | ELECTRONIKPRAXIS, Band 7, Nr. 4, 1972<br>Würzburg<br>G. LA BELLE "Analoge Torschaltungen<br>und ihre Anwendungen"<br>* Seiten 35 bis 37; Fig. 10 *<br>--- | 2 |
| A | DE - A1 - 2 630 959 (HELIOWATT)<br>* Seite 20, Absatz 4 bis Seite 21,<br>Absatz 3; Fig. 2 *<br>-- | 1 |
| A | DE - A - 2 108 279 (INSTEM)<br>* Seite 1 bis Seite 2, Absatz 4 *<br>— | |
| A | US - A - 3 981 005 (JUN TAKAYAMA et al.)<br>* gesamtes Dokument *<br>----- | |

**KLASSIFIKATION DER ANMELDUNG (Int.Cl.)**

G 01 R 21/00
G 01 R 11/00
G 01 R 15/08
H 03 K 13/02

**RECHERCHIERTE SACHGEBIETE (Int. Cl.)**

G 01 R 11/00
G 01 R 15/08
G 01 R 21/00
H 03 K 13/02

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde
liegende Theorien oder
Grundsätze
E: kollidierende Anmeldung
D: in der Anmeldung angeführtes
Dokument
L: aus andern Gründen
angeführtes Dokument
&: Mitglied der gleichen Patentfamilie, übereinstimmendes
Dokument

X Der vorliegende Recherchenbericht wurde für alle Patentansprüche erstellt.

| Recherchenort | Abschlußdatum der Recherche | Prüfer |
|---|---|---|
| Berlin | 22-10-1979 | LEMMERICH |

EPA form 1503.1 06.78